# EUROPEAN PATENT APPLICATION

(11) **EP 4 783 817 A2**
(43) Date of publication of application: **29.07.2026**
(21) Application number: 26151332.9
(22) Date of filing: 12.01.2026
(51) Int. Cl.: H10W 44/20, H10W 20/00, H10W 20/20, H10W 70/60, H10W 90/22, H10W 90/10, H10W 90/20

(54) **CONVEYING RADIO FREQUENCY SIGNALS THROUGH AN INTERPOSER**

(30) Priority: 27.01.2025 US 202519037470
(71) Applicant: NXP USA, Inc., Austin, TX 78735 (US)
(72) Inventor: Gong, Zhiwei, 5656AG Eindhoven (NL); Lo, Tsung Nan, 5656AG Eindhoven (NL); Chuang, Wen Yuan, 5656AG Eindhoven (NL)
(74) Representative: Colaiuda, Antonella

(57) **Abstract**

An integrated circuit assembly includes first and second circuit portions, an interposer vertically disposed between the first and second circuit portions, the interposer having a plated through hole with a metallic sidewall, and a metallic pillar that extends through the plated through hole without touching the metallic sidewall. The metallic pillar and the plated through hole together form a vertical coaxial structure constructed and arranged to convey RF (radio frequency) signals between the first and second circuit portions. Embodiments are directed to both the integrated circuit assembly and to a method of manufacturing the integrated circuit assembly.

## Description

### TECHNICAL FIELD

This disclosure is directed generally to semiconductor device assemblies, and more specifically to multichip integrated circuit assemblies that convey radio frequency signals between components within a device package.

### BACKGROUND

Some semiconductor device assemblies are configured to convey RF (radio frequency) signals along transmission paths between different components within a package. For making vertical connections, a first semiconductor die (also called a "chip") may include a vertical signal pillar surrounded by an array of vertical ground pillars disposed in a circle around the signal pillar. The vertical ground pillars form a via fence or cluster, which can provide a grounded shield for the signal pillar. The vertical signal pillar and ground pillars may extend from the first chip to a second chip or other circuit disposed above or below the first chip. For making horizontal connections between laterally adjacent chips, a packaging substrate may include a metal trace, such as a microstrip line, which is surrounded on both sides by a via fence. The microstrip line and the via fences may extend laterally between the chips for making RF connections between the chips.

### SUMMARY

Certain embodiments are directed to an integrated circuit assembly. The integrated circuit assembly includes first and second circuit portions, an interposer vertically disposed between the first and second circuit portions, the interposer having a plated through hole with a metallic sidewall, and a metallic pillar that extends through the plated through hole between the first and second circuit portions without touching the metallic sidewall. The metallic pillar and the plated through hole together form a vertical coaxial structure constructed and arranged to convey RF (radio frequency) signals between the first and second circuit portions.

Other embodiments are directed to a method of manufacturing a circuit assembly. The method includes providing a first circuit portion having a metallic pillar and applying an interposer to the first circuit portion. The interposer has a plated through hole with a metallic sidewall, and the adhering is performed such that the metallic pillar of the first circuit portion extends through the plated through hole of the interposer without touching the metallic sidewall and forms a vertical coaxial structure within the interposer. The method further includes applying a second circuit portion to the interposer opposite the first circuit portion such that the metallic pillar electrically connects to a metal region of the second circuit portion. The coaxial structure is thereby disposed to convey RF (radio frequency) signals between the first circuit portion and the second circuit portion.

Further embodiments are directed to an integrated circuit assembly. The integrated circuit assembly includes a semiconductor die having a metallic pillar, an interposer disposed against the semiconductor die, the interposer having a plated through hole with a metallic sidewall, and a vertical coaxial structure having a center conductor formed by the metallic pillar and a shield formed by the plated through hole. The metallic pillar extends through the plated through hole without touching the metallic sidewall. The vertical coaxial structure is constructed and arranged to convey RF (radio frequency) signals through the interposer.

The foregoing summary is presented for illustrative purposes to assist the reader in readily grasping example features presented herein; however, this summary is not intended to set forth required elements or to limit embodiments hereof in any way. One should appreciate that the above-described features can be combined in any manner that makes technological sense, and that all such combinations are intended to be disclosed herein, regardless of whether such combinations are identified explicitly or not.

### BRIEF DESCRIPTION OF THE SEVERAL VIEWS OF THE DRAWINGS

The foregoing and other features and advantages will be apparent from the following description of particular embodiments, as illustrated in the accompanying drawings, in which like reference characters refer to the same or similar parts throughout the different views. The drawings are not necessarily to scale, emphasis instead being placed upon illustrating the principles of various embodiments.
FIG. 1 is an elevated front, cross-sectional view of an integrated circuit assembly according to one or more embodiments.
FIG. 2 is an elevated front, exploded view of the integrated circuit assembly of FIG. 1.
FIG. 3 is an isometric view of an example interposer according to one or more embodiments.
FIG. 4 is a cross-sectional view of the interposer of FIG. 3.
FIGS. 5A through 5E are respective isometric views of the interposer of FIGS. 3 and 4 undergoing a series of manufacturing steps, according to one or more embodiments.
FIG. 6 is a close-up isometric view of a blind via formed during a manufacturing step of FIG. 5D, according to one or more embodiments.
FIG. 7 is a close-up isometric view of the blind via during a manufacturing step of FIG. 5E, according to one or more embodiments.
FIG. 8 is an isometric view of a variant of the interposer shown in FIGS. 3-7.
FIG. 9 is an elevated front, cross-sectional view of a first packaged electronic device that includes the integrated circuit assembly of any of the foregoing figures, according to one or more embodiments.
FIG. 10 is an elevated front, cross-sectional view of a second packaged electronic device that includes the integrated circuit assembly of any of the foregoing figures, according to one or more embodiments.
FIG. 11 is a flowchart showing an example method of manufacturing the integrated circuit assembly of any of the foregoing figures, according to one or more embodiments.

### DETAILED DESCRIPTION

The above-described approaches for conveying RF signals within a device package involve deficiencies. For example, via fences can consume considerable space due to design rule limitations. Such space consumption can result in tradeoffs. For example, a designer may only partially implement a via fence, such that it does not completely surround a center conductor, resulting in impaired signal integrity and performance. Even if the via fence is implemented completely, the via fence still results in undesirable insertion loss due to its discontinuous structure. What is needed, therefore, is a solution for conveying RF signals between components of a device package, which is space-efficient and preserves signal integrity.

According to one or more embodiments, the above need can be addressed at least in part by techniques for conveying RF signals using an interposer. These techniques include providing a vertical coaxial structure within the interposer for conveying RF signals between first and second circuit portions disposed above and below the interposer. The vertical coaxial structure has a center conductor formed by a metallic pillar and a shield formed by a plated through hole in the interposer. The metallic pillar is electrically coupled to the first and second circuit portions and extends through the plated through hole without touching walls of the plated through hole. Advantageously, the coaxial structure within the interposer can convey RF signals without the need for space-consuming and lossy via fences, allowing for compact designs. In addition, the coaxial structure has a defined and consistent characteristic impedance, which enables RF signals to maintain high signal integrity as they pass between the first and second circuit portions.

According to one or more embodiments, the first circuit portion includes a chip, and the metallic pillar is formed on the chip, e.g., as a bumped copper pillar that extends from the chip. Inside the chip, the metallic pillar may be electrically coupled to an RF signal node, such as an amplifier, power splitter, sensor, transmission line, or the like. In one or both of the first and second circuit portions, the plated through hole of the interposer may be electrically coupled to a reference node, such as ground.

According to one or more embodiments, the second circuit portion includes a routing structure, such as a build-up package structure or a pre-made routing structure, such as one having an organic substrate. To form a build-up package structure, a package-level process deposits alternating layers of patterned metal and dielectric material, which includes forming a metal region upon the metallic pillar to form an electrical connection.

To apply a pre-made routing structure, the metallic pillar of the coaxial structure is tipped with solder, and an assembly process aligns and brings together the pre-made routing structure and the interposer and reflows the solder to bond the metallic pillar to an exposed metal region of the pre-made routing structure.

According to one or more embodiments, the interposer is constructed and arranged to couple the first circuit portion to a third circuit portion, which is disposed on one side of the first circuit portion. For example, the interposer includes a plated channel having a first end vertically aligned with the first circuit portion and a second end vertically aligned with the third circuit portion. A first terminal extends from the first circuit portion into the plated channel at the first end, and a second terminal extends from the second circuit portion into the plated channel at the second end. The plated channel forms a waveguide for conveying RF signals between the first and third circuit portions. In an example, the first and second circuit portions are first and second chips.

Embodiments of the improved techniques will now be described. One should appreciate that such embodiments are provided by way of example to illustrate certain features and principles but are not intended to be limiting.

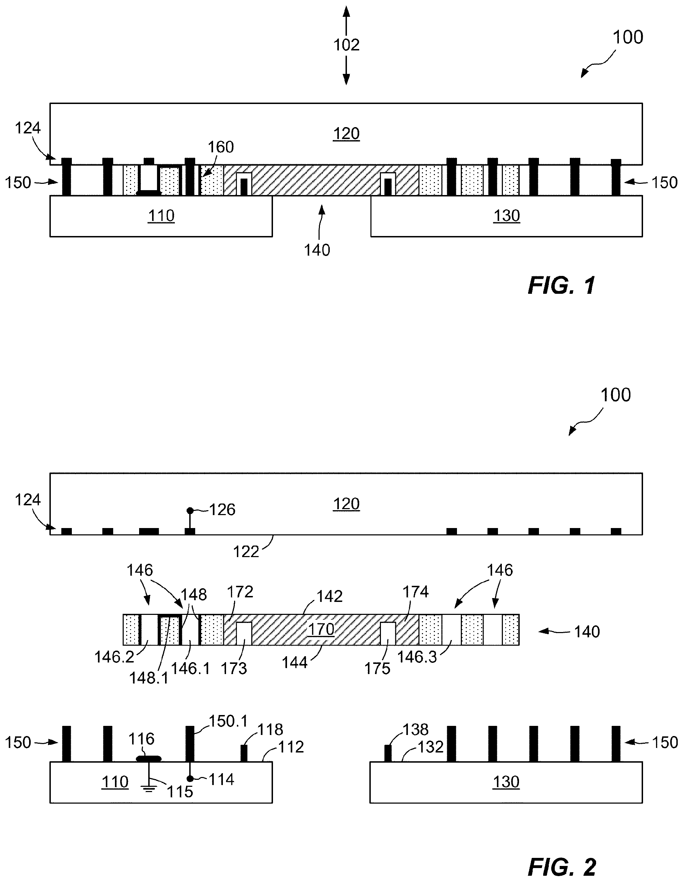

FIG. 1 is a cross-sectional view of an integrated circuit assembly 100 according to one or more embodiments. Here, the integrated circuit assembly 100 includes a first circuit portion 110, a second circuit portion 120, a third circuit portion 130, and an interposer 140. The third circuit portion 130 is disposed to one side of the first circuit portion 110. FIG. 2 is an exploded view of the same integrated circuit assembly 100.

The first and third circuit portions 110 and 130 have respective upper surfaces 112 and 132 (FIG. 2), and the routing structure 120 has a lower surface 122. The interposer 140 has upper and lower surfaces 142 and 144, respectively. As used herein, the term "vertical" and variants thereof refer to relationships along a spatial dimension indicated by line 102 in FIG. 1, which is fixed relative to the assembly 100 and is invariant to rotation of the assembly 100. Along the same lines, the terms "upper," "lower," "above," and "below," and the like refer to spatial relationships along the axis indicated by line 102.

In an example, the first and third circuit portions 110 and 130 are respective semiconductor dies (chips), and the second circuit portion 120 is a routing structure, such as a build-up packaging structure or a pre-made routing structure, which may be a separately manufactured piece. The interposer 140 is composed at least in part of glass or silicon, but other materials may be used, such as ceramic, polymer, or circuit board substrate materials (e.g., FR4 material). In some examples, the interposer 140 may be affixed to the first and third circuit portions 110 and 130, e.g., using adhesive or solder.

As further shown in FIGS. 1 and 2, metallic pillars 150 extend between the first and second circuit portions 110 and 120, as well as between the second and third circuit portions 120 and 130. In an example, the metallic pillars 150 are copper pillars formed upon electrical contacts on the surfaces 112 and 132 of the first and third circuit portions 110 and 130, respectively, e.g., using electroplating or 3D printing. Other materials besides copper may be used, however, such as gold, nickel, silver, stainless steel, or conductive metal ink, as nonlimiting examples. The metallic pillars 150 join with metal regions 124 exposed at the bottom surface 122 of the routing structure 120. The metal regions 124 may be conductive pads or lands, or may themselves be metallic pillars in some examples. Some of the metallic pillars 150 extend through vertical holes 146 in the interposer 150.

According to one or more embodiments, the holes 146 include a plated through hole 146.1, i.e., a hole that extends completely through the interposer 140 and has a metal-plated sidewall 148. In an example, the sidewall 148 forms a cylindrical metal region that completely covers the interior of the hole 146.1. Also, one of the metallic pillars 150, labeled 150.1, extends through the plated through hole 146.1 without touching the sidewall 148, thereby forming a vertical coaxial structure 160 (FIG. 1). In the coaxial structure 160, the metallic pillar 150.1 provides the center conductor and the plated through hole 146.1 provides the shield.

In an example, the metallic pillar 150.1 is electrically coupled to a first RF signal node 114 in the first circuit portion 110. In the completed assembly 100, the metallic pillar 150.1 is further electrically coupled to a second RF signal node 126 in the second circuit portion 110. The first and second RF signal nodes 114 and 126 may be RF inputs or RF outputs of RF circuitry, such as amplifiers, power splitters, sensors, and/or transmission lines, for example.

In an example, the sidewall 148 of the plated through hole 146.1 is electrically coupled to a reference node 115, which may be a local ground, system ground, or some other stable voltage reference. For example, the interposer 140 may include a second plated through hole 146.2, which is electrically coupled to the sidewall 148 via a conductive trace 148.1 on the interposer 140. The second plated through hole 146.2 is electrically coupled to the reference node 115 via solder 116, such as conductive paste or a solder ball, which covers a conductive pad or land on the surface 112, for example. In this manner, the plated through holes 146.1 and 146.2 are both connected to the reference node 115. Although the reference node 115 is pictured within the first circuit portion 110, it may alternatively be disposed within the second circuit portion 120. Further, reference nodes 115 may also be provided in both circuit portions 110 and 120, and such reference nodes 115 may be connected together through the interposer 140. In some examples, the conductive trace 148.1 alternatively or additionally may be provided within the second circuit portion 120, for connecting the sidewall 148 of the plated through hole 146.1 to the reference node 115.

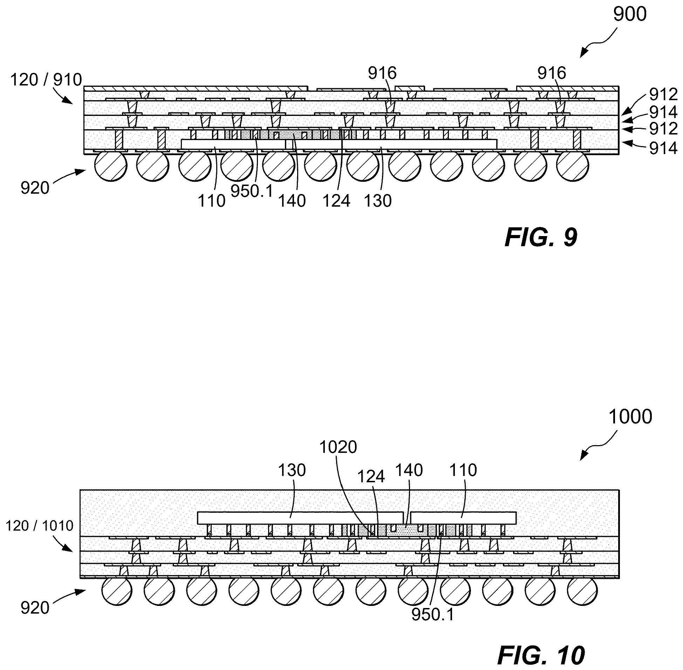

The coaxial structure 160 provides a compact and effective way of conveying RF signals vertically through the interposer 140. Rather than providing a via fence, as in the prior approach, the coaxial structure 160 instead implements a shield using the plated through hole 146.1, which can consume much less space than a via fence and can provide improved performance. For example, the defined and stable geometry of the coaxial structure 160 provides consistent characteristic impedance over its length (the height of the interposer 140). Such characteristic impedance may be established by design, based on the thickness of the metallic pillar 150.1, the diameter of the plated through hole 146.1, and the dielectric constant of the material in the space between the metallic pillar 150.1 and the plated through hole 146.1. For simplicity of manufacture as well as performance, the dielectric material in the space between the metallic pillar 150.1 and the plated through hole 146.1 can be air, but other materials can be used, such as polyimide (PI), polybenzoxazole (PBO), polyphenylene oxide (PPO), or other suitable dielectric materials . Such materials can be applied during subassembly of the interposer 140 or when forming the second circuit portion 120 using build-up material or encapsulation material (FIGS. 9 and 10). Although only a single coaxial structure 160 is shown in FIGS. 1 and 2, one should appreciate that the interposer 140 can contain any number of coaxial structures 160.

The height of the interposer 140 may vary based on design considerations, with typical heights ranging between about 40 and 100 microns. The length and width of the interposer 140 are typically on the order of millimeters (mm), such as between about 3 and 10 mm. The metallic pillars 150 are typically about 30-50 microns in diameter and are about as long as the interposer 140 is high-between about 40 and 100 microns.

In general, the taller the interposer 140 is made, the better the electromagnetic isolation is between the first and second circuit portions 110 and 120, as well as between the second and third circuit portions 120 and 130. Indeed, the coaxial structure 160 allows the interposer 140 to be arbitrarily tall without substantially increasing insertion loss of RF signals passed through the interposer 140, thus allowing isolation to be increased without sacrificing performance.

The interposer 140 may contain additional features, such as non-plated through holes and various traces, i.e., patterned conductive areas. Non-plated through holes, such as hole 146.3, can provide vertical paths through the interposer 140 for metallic pillars 150 that convey non-RF signals, such as power, ground, and lower-frequency signals, between the first and second circuit portions 110 and 120 and between the second and third circuit portions 120 and 130.

According to one or more embodiments, the interposer 140 further includes a waveguide 170 constructed and arranged to convey RF signals laterally, e.g., between the first circuit portion 110 and the third circuit portion 130. The waveguide 170 may be realized as a rectangular waveguide having a channel with a rectangular cross section and metal-plated walls. The waveguide 170 has a first end 172 that vertically overlaps with the first circuit portion 110 and a second end 174 that vertically overlaps with the third circuit portion 130. A first terminal 118 extends from the first circuit portion 110 and into a first opening 173 at the first end 172 of the waveguide 170. Likewise, a second terminal 138 extends from the third circuit portion 130 and into a second opening 175 at the second end 174 of the waveguide 170. In an example, the first and second terminals 118 and 138 are metallic studs, which may be formed as copper pillars, for example. In one or more embodiments, the terminals 118 and 138 extend into the respective openings 173 and 175 and partway through the height of the interposer 140, where they act as antennas for sending and receiving RF signals. For example, an RF signal may be launched from the terminal 118, travel down the waveguide 170, and be received by the terminal 138. The terminals 118 and 138 can extend into the interposer 140 to varying heights, however, and can extend entirely through the interposer 140 in some examples. The interposer 140 may include any number of waveguides 170. Accordingly, the interposer 140 may provide both vertical and horizontal pathways for conveying RF signals between circuit portions.

Certain features of the depicted integrated circuit assembly 100 may be omitted in one or more embodiments. For example, the third circuit portion 130 and the waveguide 170 may be omitted when horizontal RF connections are not needed. Also, one or more embodiments may exclude the second circuit portion 120. For example, the integrated circuit assembly 100 may be partially assembled with just the first circuit portion 110 and the interposer 140, with the intention of adding the second circuit portion 120 later (and possibly by a different manufacturer).

In an example, the integrated circuit assembly 100 is part of a single device package, such as a 2.5D integrated circuit package. Examples of such a package are described further below.

In example operation, the first circuit portion 110 generates an RF signal at node 114. The RF signal propagates through the coaxial structure 160 of the interposer 140 and into the second circuit portion 120. If the second circuit portion 120 is a routing structure, the RF signal may continue to propagate through a transmission line (not shown) within the routing structure, which may extend to a package lead or to another chip within the same package. The integrated circuit assembly 100 may further convey RF signals laterally between the first and third circuit portions 110 and 130 using waveguides 170 within the interposer 140.

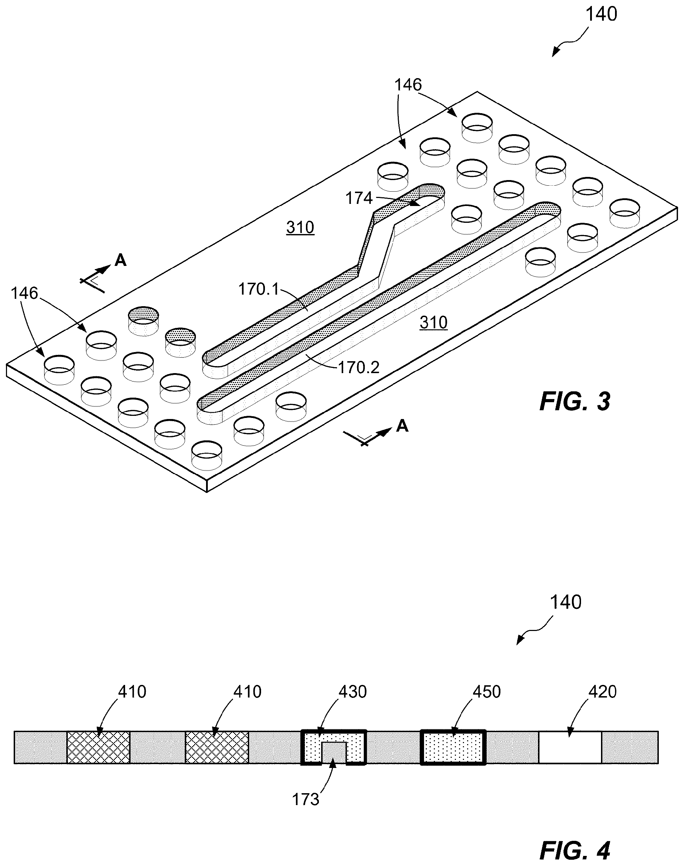

FIG. 3 is a transparent, perspective view of an example interposer 140 according to one or more embodiments. FIG. 4 is a cross-sectional view of the same interposer 140 taken along line A-A of FIG. 3. As shown, the interposer 140 includes a substrate 310 having holes 146 and waveguides 170 (170.1 and 170.2) formed therein. Holes 410 (FIG. 4) are plated through holes, such as holes 146.1 and 146.2 of FIG. 2, and holes 420 are non-plated through holes, such as hole 146.3 of FIG. 2. Region 430 depicts an end 172 of the waveguide 170.1, which includes an opening 173 (FIG. 2). Region 450 is a cross-section of the waveguide 170.2. The thickened lines surrounding regions 430 and 450 represent metal walls of the respective waveguides. In some examples, each waveguide 170 is surrounded on all sides (6 sides) by metal walls, with small areas 173 and 175 left unmetallized to allow for entry of terminals 118 and 138 (FIG. 2).

Although the waveguides 170 are seen to occupy the entire height of the interposer 140, i.e., between the upper surface 142 and the lower surface 144 (FIG. 2), this is just an example. Alternatively, the waveguides 170 may extend over only part of the height of the interposer 140. Allowing the height of the waveguides to vary provides designers with additional options for optimizing electrical properties of the waveguides and therefore performance.

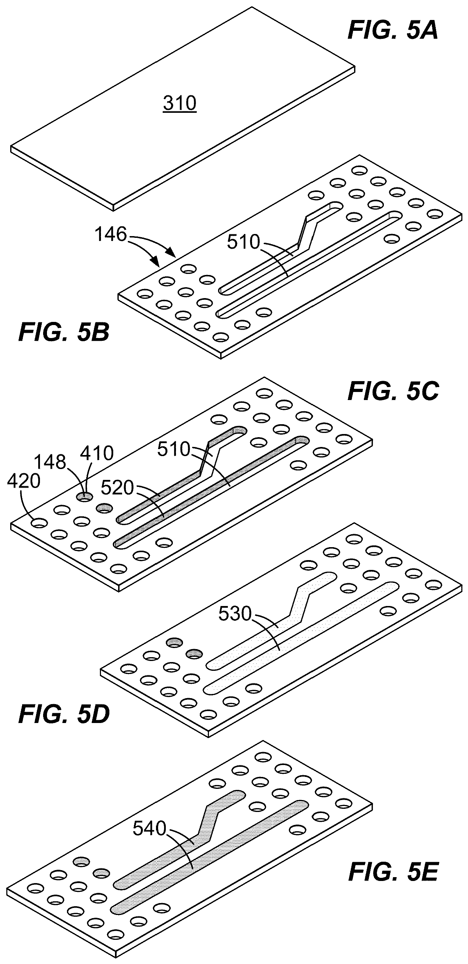

FIGS. 5A through 5E show an example sequence of steps for manufacturing the interposer 140. In FIG. 5A, a substrate 310 (FIG. 3) is provided. The substrate 310 may be formed from glass or silicon, for example, or other insulative materials, such as polymer-based circuit board material.

In FIG. 5B, holes 146 and channels 510 are formed within the substrate 310. The holes and channels may be formed by etching, drilling, routing, or the like.

In FIG. 5C, patterned metallization is applied to the drilled substrate to apply metal to the inner sidewalls 148 of the plated through holes 410, as well as to inner walls 520 of channels 510. The patterned metallization prevents metal from depositing in other areas, such as non-plated through holes 420. Metal may be applied by sputtering, electroplating, spraying, or the like, for example.

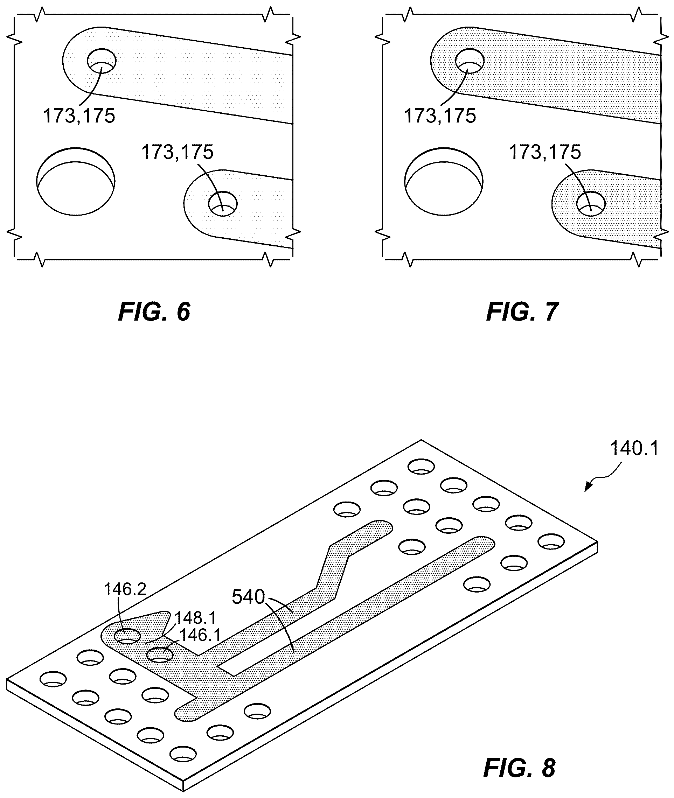

In FIG. 5D, the channels 510 are filled with dielectric material. For example, a low-loss dielectric material is used, such as PI, PBO, PPO, or other suitable dielectric materials. In some examples, the channels 510 are overfilled with dielectric material, and additional steps of grinding and/or polishing are performed on the upper and lower surfaces 142 and 144 (FIG. 2), such that the dielectric material is flush with those surfaces. As shown in FIG. 6, openings 173 and 175 may be provided within the dielectric material at the ends 172 and 174 of each waveguide 170, to provide space for terminals 118 and 138 to enter during assembly. The openings 173 and 175 may be provided as blind vias, for example, which extend vertically only partway through the channels 510.

In FIG. 5E, a second metallization step is performed, this time to apply metal 540 over the dielectric material 530 at the top and bottom surfaces of the channels 510. Once the acts accompanying FIGS. 5A through 5E are finished, the waveguides 170 are completely enclosed by metal, except for small gaps left for openings 173 and 175 (FIG. 7).

FIG. 8 shows an example interposer 140.1 according to one or more embodiments. The interposer 140.1 is similar to the interposer 140 described previously, except that additional features are provided for connecting plated through holes 410 and metal 540 of waveguides 170 to the reference node 115, e.g., ground, in the manner described in connection with FIGS. 1 and 2. For example, the plated through hole 146.1, which is to receive the metallic pillar 150.1, is electrically connected via the trace 148.1 to the plated through hole 146.2, which in the completed assembly 100 connects to the reference node 115 (FIG. 2). As shown in FIG. 8, the trace 148.1 is further extended to the metal 540 applied to the channels 510 of the waveguides 170 (FIG. 5E). In this manner, the interposer 140.1 shares a single connection to the reference node 115 among multiple plated through holes and waveguides.

FIG. 9 is a cross-sectional view of a molded, packaged electronic device 900 that contains the integrated circuit assembly 100, according to one or more embodiments. The integrated circuit assembly 100 includes the first circuit portion 110, the second circuit portion 120, the third circuit portion 130, and the interposer 140 or 140.1, both of which will be referred to going forward using reference 140. The electronic device 900 may be packaged using FOWLP (fanout wafer-level packaging), PLP (panel-level packaging), or any other suitable packaging techniques, for example. The packaged electronic device 900 is shown as a ball grid array (BGA), but other arrangements are possible, such as a land grid array (LGA), pin grid array (PGA), or the like, as nonlimiting examples.

As shown, the second circuit portion 120 is a routing layer realized as a build-up packaging structure 910. For example, the build-up packaging structure 910 includes an alternating series of patterned metallization layers 912 and dielectric layers 914, as well as vias 916 that form vertical connections between different patterned metallization layers 912. In the example shown, the build-up structure 910 is applied directly over the interposer 140 and over the first and third circuit portions 110 and 130, and it extends outside the footprint of such portions, e.g., for providing electrical connections to device terminals 920, such as solder balls, lands, or pins.

With the depicted arrangement, metallic pillars 150 (FIGS. 1 and 2) extending upwardly from the first and third circuit portions 110 and 130 form electrical connections with metal regions 124 of the build-up structure 910, such as respective areas of the particular metallization layer 914 applied directly over the interposer 140. The metallic pillars 150 forming such connections include the metallic pillar 150.1, which forms the center conductor of the coaxial structure 160.

FIG. 10 is a cross-sectional view of another molded, packaged electronic device 1000 that contains the integrated circuit assembly 100, according to one or more embodiments. In this example, the integrated circuit assembly 100 is upside-down relative to the FIG-9 arrangement, in a so-called flip-chip (FC) arrangement, and the second circuit portion 120 is provided as a pre-made routing layer 1010, such as a routing layer having an organic substrate. The packaged electronic device 1000 is again shown as a BGA, but other arrangements are possible.

In the FIG-10 arrangement, the metallic pillars 150 are tipped with solder 1020 and the metal regions 124 are pre-formed features of the pre-made routing layer 1010. During assembly, the interposer 140/140.1 is aligned with and applied against the first and third circuit portions 110 and 130, and the combined components are aligned with the pre-made routing layer 1010. The aligned portions are then heated, such that the solder at the tips of the metallic pillars 150 reflows and fuses with the metal regions 124.

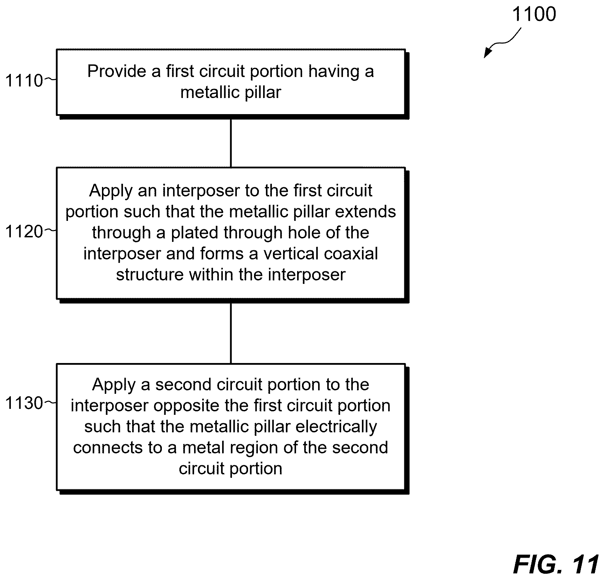

FIG. 11 shows an example method 1100 of manufacturing an integrated circuit assembly 100, such as those described in connection with FIGS. 1-10. The method 1100 is typically performed by a semiconductor fabrication facility, a foundry, an OSAT (outsourced semiconductor assembly and test facility), or by any combination of the foregoing, for example. The various acts of method 1100 may be ordered in any suitable way.

At 1110, a first circuit portion 110 having a metallic pillar 150.1 is provided. For example, the first circuit portion 110 may be a semiconductor die constructed and arranged to generate and/or receive RF signals. Examples of the semiconductor die include chips designed for radar applications and other RF communication systems. The metallic pillar 150.1 may be a copper pillar bumped onto an electrical contact on the surface 112 of the semiconductor die, for example.

At 1120, an interposer 140 is applied to the first circuit portion 110 such that the metallic pillar 150.1 extends through a plated through hole 146.1 of the interposer 140 and forms a vertical coaxial structure 160 within the interposer 140. For example, the bottom surface 144 of the interposer 140 may be adhered to the top surface 112 of the first circuit portion 110 using glue or some other adhesive, using static electricity, or using solder.

At 1130, a second circuit portion 120 is applied to the interposer 140 opposite the first circuit portion 110 such that the metallic pillar 150.1 electrically connects to a metal region 124 of the second circuit portion 120. In the FIG-9 example, applying the second circuit portion 120 includes forming a build-up structure 910 as an alternating series of patterned metal and dielectric layers. In this example, the metal region 124 is formed as a patterned metal area deposited directly onto the tip of the metallic pillar 150.1. In the FIG-10 example, applying the second circuit portion 120 includes applying a pre-made routing structure 1010 to the surface 142 of the interposer 140 and reflowing solder at the tip of the metallic pillar 150.1. Those skilled in the art will understand additional process steps may be required to fully complete the packaged electronic device 900, 1000 including for example encapsulation, ball attach, etc.

Techniques have been described of conveying RF signals through an interposer 140. The techniques include providing a vertical coaxial structure 160 within the interposer 140 for conveying RF signals between first and second circuit portions 110 and 120 disposed above and below the interposer 140. The vertical coaxial structure 160 has a center conductor formed by a metallic pillar 150.1 and a shield formed by a plated through hole 146.1 in the interposer 140. The metallic pillar 150.1 is electrically coupled to the first and second circuit portions 110 and 120 and extends through the plated through hole 146.1 without touching walls of the plated through hole 146.1. In some examples, the techniques further include providing a third circuit portion 130 disposed on one side of the first circuit portion 110 and a waveguide 170 formed within the interposer 140. The waveguide 170 extends between a first end 172 vertically aligned with the first circuit portion 110 and a second end 174 vertically aligned with the third circuit portion 130. The waveguide 170 is constructed and arranged to convey RF signals horizontally between the first and third circuit portions.

### EXAMPLES:

A first example of the improved techniques is directed to an integrated circuit assembly. The integrated circuit assembly includes first and second circuit portions, an interposer vertically disposed between the first and second circuit portions, the interposer having a plated through hole with a metallic sidewall, and a metallic pillar that extends through the plated through hole between the first and second circuit portions without touching the metallic sidewall. The metallic pillar and the plated through hole together form a vertical coaxial structure constructed and arranged to convey RF (radio frequency) signals between the first and second circuit portions.

According to one or more further embodiments, the metallic sidewall of the plated through hole is electrically coupled to a reference node in at least one of the first and second circuit portions, and the metallic pillar is electrically coupled between a first RF (radio frequency) signal node in the first circuit portion and a second RF signal node in the second circuit portion.

According to one or more further embodiments, the interposer includes a substrate composed of glass, silicon, ceramic, or polymer.

According to one or more further embodiments, the first circuit portion includes a semiconductor die and the second circuit portion includes a routing structure.

According to one or more further embodiments, the semiconductor die and the routing structure are disposed within a device package.

According to one or more further embodiments, the metallic pillar is a copper pillar that extends from the semiconductor die to a metal region of the routing structure.

According to one or more further embodiments, the integrated circuit assembly further includes a third circuit portion disposed on one side of the first circuit portion. The interposer is vertically disposed between the second circuit portion and the third circuit portion, and the interposer further includes a plated channel that extends laterally between a terminal of the first circuit portion and a terminal of the third circuit portion, the plated channel defining a rectangular waveguide constructed and arranged to convey RF signals between the first circuit portion and the third circuit portion.

According to one or more further embodiments, the terminal of the first circuit portion includes a metallic stud that extends from the first circuit portion into the plated channel at a first end of the plated channel, and the terminal of the third circuit portion includes a metallic stud that extends from the third circuit portion into the plated channel at a second end of the plated channel opposite the first end.

According to one or more further embodiments, the rectangular waveguide contains a dielectric material covered on all sides by metal.

According to one or more further embodiments, the plated channel is electrically coupled to a reference node.

A second example of the improved techniques is directed to a method of manufacturing a circuit assembly. The method includes providing a first circuit portion having a metallic pillar and applying an interposer to the first circuit portion. The interposer has a plated through hole with a metallic sidewall, and the adhering is performed such that the metallic pillar of the first circuit portion extends through the plated through hole of the interposer without touching the metallic sidewall and forms a vertical coaxial structure within the interposer. The method further includes applying a second circuit portion to the interposer opposite the first circuit portion such that the metallic pillar electrically connects to a metal region of the second circuit portion. The coaxial structure is thereby disposed to convey RF (radio frequency) signals between the first circuit portion and the second circuit portion.

According to one or more further embodiments, the method further includes providing the first circuit portion, the interposer, and the second circuit portion within a single molded device package.

According to one or more further embodiments, applying the second circuit portion to the interposer includes depositing alternating layers of patterned metal and dielectric material over the interposer.

According to one or more further embodiments, the metallic pillar is tipped with solder, and applying the second circuit portion to the interposer includes reflowing the solder to fuse the metallic pillar with the metal region.

A third example of the improved techniques is directed to an integrated circuit assembly. The integrated circuit assembly includes a semiconductor die having a metallic pillar, an interposer disposed against the semiconductor die, the interposer having a plated through hole with a metallic sidewall, and a vertical coaxial structure having a center conductor formed by the metallic pillar and a shield formed by the plated through hole. The metallic pillar extends through the plated through hole without touching the metallic sidewall. The vertical coaxial structure is constructed and arranged to convey RF (radio frequency) signals through the interposer.

According to one or more further embodiments of the third example, the integrated circuit assembly includes a routing structure disposed against the interposer opposite the semiconductor die.

According to one or more embodiments of the third example, the semiconductor die is a first semiconductor die, and the integrated circuit assembly further includes a second semiconductor die disposed on one side of the first semiconductor die. The interposer is vertically disposed between the routing structure and the second semiconductor die, and the interposer further includes a plated channel that extends between a terminal of the first semiconductor die and a terminal of the second semiconductor die. The plated channel provides a rectangular waveguide constructed and arranged to convey RF signals between the first semiconductor die and the second semiconductor die.

According to one or more embodiments of the third example, the terminal of the first semiconductor die includes a metallic stud that extends from the first semiconductor die into the plated channel at a first end of the plated channel. The terminal of the second semiconductor die includes a metallic stud that extends from the second semiconductor die into the plated channel at a second end of the plated channel opposite the first end.

According to one or more embodiments of the third example, the plated channel contains a dielectric material covered on all sides by metal.

Having described certain embodiments, numerous alternative embodiments or variations can be made. For example, although the first circuit portion 110 and the third circuit portion 130 have been described as semiconductor dies, this is merely an example, as these portions may alternatively be other RF components, such as transmission lines, interconnects, antennas, or discrete RF components, for example. Likewise, although the second circuit portion 120 has been described as a routing structure, this also is merely an example. Other examples include a semiconductor die, an antenna, a transmission line, and a discrete RF component, for example.

Further, although features have been shown and described with reference to particular embodiments hereof, such features may be included and hereby are included in any of the disclosed embodiments and their variants. Thus, it is understood that features disclosed in connection with any embodiment are included in any other embodiment.

As used throughout this document, the words *"comprising," "including," "containing,"* and *"having"* are intended to set forth certain items, steps, elements, or aspects of something in an open-ended fashion. Also, as used herein and unless a specific statement is made to the contrary, the word *"set"* means one or more of something. This is the case regardless of whether the phrase *"set of"* is followed by a singular or plural object and regardless of whether it is conjugated with a singular or plural verb. Also, a *"set of"* elements can describe fewer than all elements present. Thus, there may be additional elements of the same kind that are not part of the set. Further, ordinal expressions, such as *"first," "second," "third,"* and so on, may be used as adjectives herein for identification purposes. Unless specifically indicated, these ordinal expressions are not intended to imply any ordering or sequence. Thus, for example, a *"second"* event may take place before or after a *"first* event," or even if no first event ever occurs. In addition, an identification herein of a particular element, feature, or act as being a *"first"* such element, feature, or act should not be construed as requiring that there must also be a *"second"* or other such element, feature or act. Rather, the *"first"* item may be the only one. Also, and unless specifically stated to the contrary, *"based on"* is intended to be nonexclusive. Thus, *"based on"* should be interpreted as meaning *"based at least in part on"* unless specifically indicated otherwise. Further, although the term *"user"* as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

Also, the foregoing description refers to elements or nodes or features being *"connected"* or *"coupled"* together. As used herein, unless expressly stated otherwise, *"connected"* means that one element is directly joined to (or directly communicates with) another element, and not necessarily mechanically. Likewise, unless expressly stated otherwise, *"coupled"* means that one element is directly or indirectly joined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter. In addition, spatial and directional references are for illustration purposes and not intended to require any specific orientation of a part unless stated explicitly otherwise.

Those skilled in the art will therefore understand that various changes in form and detail may be made to the embodiments disclosed herein without departing from the scope of the following claims.

## Claims

1. An integrated circuit assembly, comprising:
first and second circuit portions;
an interposer vertically disposed between the first and second circuit portions, the interposer having a plated through hole with a metallic sidewall; and
a metallic pillar that extends through the plated through hole between the first and second circuit portions without touching the metallic sidewall, the metallic pillar and the plated through hole together forming a vertical coaxial structure constructed and arranged to convey RF (radio frequency) signals between the first and second circuit portions.

2. The integrated circuit assembly of claim 1, wherein the metallic sidewall of the plated through hole is electrically coupled to a reference node in at least one of the first and second circuit portions, and wherein the metallic pillar is electrically coupled between a first RF (radio frequency) signal node in the first circuit portion and a second RF signal node in the second circuit portion.

3. The integrated circuit assembly of claim 1 or claim 2, wherein the interposer includes a substrate composed of glass, silicon, ceramic, or polymer.

4. The integrated circuit assembly according to any preceding claim, wherein the first circuit portion includes a semiconductor die and the second circuit portion includes a routing structure.

5. The integrated circuit assembly of claim 4, wherein the semiconductor die and the routing structure are disposed within a device package.

6. The integrated circuit assembly of claim 4 or claim 5, wherein the metallic pillar is a copper pillar that extends from the semiconductor die to a metal region of the routing structure.

7. The integrated circuit assembly of claim 4 or claim 5, wherein the metallic pillar is soldered to the metal region of the routing structure.

8. The integrated circuit assembly according to any preceding claim, further comprising a third circuit portion disposed on one side of the first circuit portion,
wherein the interposer is vertically disposed between the second circuit portion and the third circuit portion, and
wherein the interposer further includes a plated channel that extends laterally between a terminal of the first circuit portion and a terminal of the third circuit portion, the plated channel defining a rectangular waveguide constructed and arranged to convey RF signals between the first circuit portion and the third circuit portion.

9. The integrated circuit assembly of claim 8, wherein the terminal of the first circuit portion includes a metallic stud that extends from the first circuit portion into the plated channel at a first end of the plated channel, and wherein the terminal of the third circuit portion includes a metallic stud that extends from the third circuit portion into the plated channel at a second end of the plated channel opposite the first end.

10. The integrated circuit assembly of claim 8 or claim 9, wherein the rectangular waveguide contains a dielectric material covered on all sides by metal.

11. The integrated circuit assembly of any of claims 8 to 10, wherein the plated channel is electrically coupled to a reference node.

12. A method of manufacturing a circuit assembly, comprising:
providing a first circuit portion having a metallic pillar;
applying an interposer to the first circuit portion, the interposer having a plated through hole with a metallic sidewall, the adhering performed such that the metallic pillar of the first circuit portion extends through the plated through hole of the interposer without touching the metallic sidewall and forms a vertical coaxial structure within the interposer; and
applying a second circuit portion to the interposer opposite the first circuit portion such that the metallic pillar electrically connects to a metal region of the second circuit portion, the coaxial structure thereby disposed to convey RF (radio frequency) signals between the first circuit portion and the second circuit portion.

13. The method of claim 12, further comprising providing the first circuit portion, the interposer, and the second circuit portion within a single molded device package.

14. The method of claim 12 or claim 13, wherein applying the second circuit portion to the interposer includes depositing alternating layers of patterned metal and dielectric material over the interposer.

15. The method of any of claims 12 to 14, wherein the metallic pillar is tipped with solder, and wherein applying the second circuit portion to the interposer includes reflowing the solder to fuse the metallic pillar with the metal region.
